(19) Europäisches Patentamt

European Patent Office

Office européen des brevets

(11) Veröffentlichungsnummer : **0 292 064 B1**

(12) **EUROPÄISCHE PATENTSCHRIFT**

(45) Veröffentlichungstag der Patentschrift :
**07.08.91 Patentblatt 91/32**

(51) Int. Cl.⁵ : **G01R 33/54**

(21) Anmeldenummer : **88200981.4**

(22) Anmeldetag : **17.05.88**

(54) **Kernspintomographie-Anlage mit digitalem Sender/Empfänger.**

(30) Priorität : **19.05.87 NL 8701195**

㊸ Veröffentlichungstag der Anmeldung.:
**23.11.88 Patentblatt 88/47**

(45) Bekanntmachung des Hinweises auf die
Patenterteilung :
**07.08.91 Patentblatt 91/32**

(84) Benannte Vertragsstaaten :
**CH DE FR GB LI NL**

(56) Entgegenhaltungen :
**EP-A- 0 107 294**
**EP-A- 0 165 057**
**EP-A- 0 182 107**
**EP-A- 0 219 206**
**US-A- 4 623 843**

(56) Entgegenhaltungen :
**IEEE TRANSACTIONS ON BIOMEDICAL ENGI-**
**NEERING, Band BME-34, Nr. 4, April 1987,**
**Seiten 310-313, IEEE, New York, US; D.J. JEN-**
**SEN et al.: "An incremental phase shifter and**
**frequency modulator for magnetic resonance**
**imaging and spectroscopy"**
**IDEM**

(73) Patentinhaber : **N.V. Philips'**
**Gloeilampenfabrieken**
**Groenewoudseweg 1**
**NL-5621 BA Eindhoven (NL)**

(72) Erfinder : **Mehlkopf, Antoon Frans**
**c/o INT. OCTROOIBUREAU B.V. Prof.**
**Holstlaan 6**
**NL-5656 AA Eindhoven (NL)**
Erfinder : **Den Boef, Johannes Hendrik**
**c/o INT. OCTROOIBUREAU B.V. Prof.**
**Holstlaan 6**
**NL-5656 AA Eindhoven (NL)**

(74) Vertreter : **Faessen, Louis Marie Hubertus et al**
**INTERNATIONAAL OCTROOIBUREAU B.V. 6**
**Prof. Holstlaan**
**NL-5656 AA Eindhoven (NL)**

**Beschreibung**

Die Erfindung betrifft eine Kernspintomographie-Anlage mit einem Magnetsystem zum Erzeugen eines statischen homogenen Magnetfelds und zum Erzeugen magnetischer Gradientenfelder, mit einem Hf-Sender und Hf-Empfänger zum Erzeugen und Detektieren von Kernresonanzsignalen und mit einer Verarbeitungs- und Steueranordnung zum Verarbeiten der detektierten Resonanzsignale zum Steuern des Hf-Senders und Hf-Empfängers und des Magnetsystems, wobei der Sender ein Sendesignal erzeugt, dessen Sendefrequenz von der Frequenz eines dem Empfänger zuzuführenden Bezugssignals zum Demodulieren eines mit dem Sendesignal erzeugten Resonanzsignals abweicht, wobei eine Abtastschaltung zum Abtasten des demodulierten Resonanzsignals vorgesehen ist.

Eine derartige Anlage ist aus der europäischen Patentanmeldung 0165057 bekannt Weitere Dokumente, die den Stand der Technik Jeigen, sind : EP-A-219206 und der Artikel von D.J. Jensen et al. in IEEE Transactions on Biomedical Engineering, Band BME-34 (1987) Seiten 310-313. In der europäischen Patentanmeldung 0165051 ist der Wert eines zuverlässigen und genau funktionierenden Hf-Senders und Hf-Empfängers beschrieben. In der Patentanmeldung ist weiter beschrieben, auf welche Weise die Genauigkeit im Hf-Senders durch das Erzeugen des den Träger modulierenden Modulationssignals mittels digitaler Schalttechniken verbessert werden kann. Jedoch erfährt der Hf-Empfänger immer noch störenden Einfluß von Drift- und Offset-Problemen, da angenommen werden darf, daß er die für Kernspinresonanz-Anwendungen übliche Quadraturdetektionsanordnung enthält. Drift- und Offset-Probleme haben in dem letztlich zu rekonstruierenden Bild ungewünschte Auswirkungen, wie z.B. Streifenmuster, Grauwertverschiebung, usw.

Der Erfindung liegt die Aufgabe zugrunde, eine Kernspintomographie-Anlage zu schaffen, in der ein Hf-Sender/Empfänger angewandt wird, der niedrigere Abgleichkosten benötigt, einfach bedienbar und preisgünstiger herstellbar ist, eine viel größere Reproduzierbarkeit und keine unerwünschten Auswirkungen in einem zu rekonstruierenden Bild hat.

Zur Lösung dieser Aufgabe ist eine Kernspintomographie-Anlage erfindungsgemäß dadurch gekennzeichnet, daß das dem Empfänger zugeführte Bezugssignal eine derartige Frequenz hat, daß das Frequenzband des demodulierten und abgetasteten Resonanzsignals sich einseitig in bezug auf die Frequenz 0 Hz befindet, wobei weiter Mittel zum Beibehalten einer Phaseninformation der Resonanzsignale in den aufeinanderfolgenden Meßsequenzen vorgesehen sind.

Bei der Kernspintomographie-Anlage ist durch die Maßnahme, daß das nach der Abtastung verfügbar gewordene Frequenzband des Resonanzsignals einseitig in bezug auf die 0 Hz liegt, erreicht, daß im Sender/Empfänger kein Übersprechen vom Sendesignal nach dem Empfangssignal erfolgt, da das Sendesignal auf eine andere Frequenz gebracht ist, und daß im zu verarbeitenden Frequenzband die äußerst niedrigen Frequenzen um 0 Hz herum und die 0 Hz selbst nicht auftreten. Die Folge der Maßnahme ist, daß es keine Offset- oder Drift-Probleme gibt. Auch die Empfindlichkeit des 0-Hz-Signals, das beim Stand der Technik durch Übersprechen eine Grauverschiebung im rekonstruierten Bild verursacht, ist beseitigt.

Die Kernspintomographie-Anlage nach der Erfindung ist mit Mitteln zum Beibehalten von Phaseninformation der Resonanzsignale in den aufeinanderfolgenden Meßsequenzen versehen. Bei der Rekonstruktion einer Verteilung von Kernspinmagnetisation in einem Teil eines Objekts wird davon ausgegangen, daß die in den verschiedenen Meßsequenzen erzeugten Resonanzsignale zu einem bestimmten Zeitpunkt in der Meßsequenz (beispielsweise zum Echomoment bei Kernspinechotechnik) immer die gleiche Phase haben (abgesehen von bewußt eingeführten Phasenunterschieden, beispielsweise durch Gradientenfelder). Beispielsweise durch die Verwendung eines Triggerimpulses zum Starten eines Meßzyklus, der aus der Phase eines Signals eines Digitalfrequenzsynthesizers abgeleitet ist, der mit einem Signal aus einem Oszillator mit Phasenverriegelung vermischt wird, um ein Sendesignal zu erzeugen, ist das Beibehalten von Phaseninformation möglich. Weiter ist es möglich, aus Steuersignalen, die ein Steuer- und Regeleinheit zum Einstellen eines Digitalfrequenzsynthesizers (Frequenz- und Phasensteuersignale) verwendet, Phaseninformation beispielsweise durch die Steuer- und Regeleinheit abzuleiten, wobei die Phaseninformation im Empfänger zum Durchführen einer erforderlichen Phasenkorrektur verwendet wird.

Ein Ausführungsbeispiel einer Kernspintomographie-Anlage nach der Erfindung ist dadurch gekennzeichnet, daß der Hf-Sender/Empfänger ein Hybridsender/Empfänger ist, bei dem der Sender außer einem Digitalfrequenzsynthesizer einen Digital/Analog-Wandler und eine Sendefrequenzmischstufe sowie einen Hochfrequenzleistungs-Verstärker enthält, die in Reihe aneinandergeschaltet sind, wobei der Empfänger einen Vorverstärker, eine Empfangsfrequenzmischstufe und einen Analog/Digital-Wandler enthält, wobei die Sendefrequenz-Mischstufe an einen Ausgang eines Oszillators mit Phasenregelkreis und die Empfangsfrequenzmischstufe entweder an den Ausgang des Oszillators mit Phasenregelkreis oder an den Ausgang der Sendefrequenzmischstufe angeschlossen sind. Bei der erfindungsgemäßen Kernspintomographie-Anlage sind die analogen Teile des Digitalsenders und des Digitalempfängers auf ein Mindestmaß beschränkt, wodurch niedrigere Abgleichkosten auftreten (d.h. keine Kosten für den Digitalteil), Sender und Empfänger auf einfachere Weise prüfbar und diese Prüfungen automatisierbar sind, wodurch sich die Prüfungskosten reduzieren. Weiter sind die Herstellungskosten niedriger und können die erzeugten Hochfrequenzsignale immer mit hoher Genauigkeit reproduzierbar verarbeitet werden.

Eine bevorzugte Ausführungsform einer erfindungsgemäßen Kernresonanzanordnung ist dadurch gekennzeichnet, daß die Sendefrequenz-Mischstufe ein Einseitenbandmodulator mit einem ersten und einem zweiten Vervielfacher, von denen Ausgänge an eine Addierschaltung und ein erster Ausgang des ersten und des zweiten Vervielfachers ein Bezugssignal mit einer ersten bzw. zweiten Phase empfangen, wobei der Phasenunterschied zwischen den Bezugssignalen 90° beträgt, und daß der digitale Synthesizer einem zweiten Eingang des ersten und des zweiten Vervielfachers ein erstes bzw. zweites Signal zuführt, wobei der Phasenunterschied zwischen den Signalen an den beiden Eingängen der Vervielfacher 90° beträgt und eines der vom Synthesizer gelieferten Signale invertierbar ist.

Ausführungsbeispiele der Erfindung werden nachstehend an Hand der Zeichnung näher erläutert. Es zeigen

Fig. 1 eine erfindungsgemäße Kernspintomographie-Anlage,

Fig. 2 einen erfindungsgemäßen Digitalsender/Empfänger,

Fig. 3 und 4 den Digitalsender bzw. Digitalempfänger nach Fig. 2 mit weiteren Einzelheiten, und

Fig. 5 ein bevorzugtes Ausführungsbeispiel eines Teils des digitalen Senders.

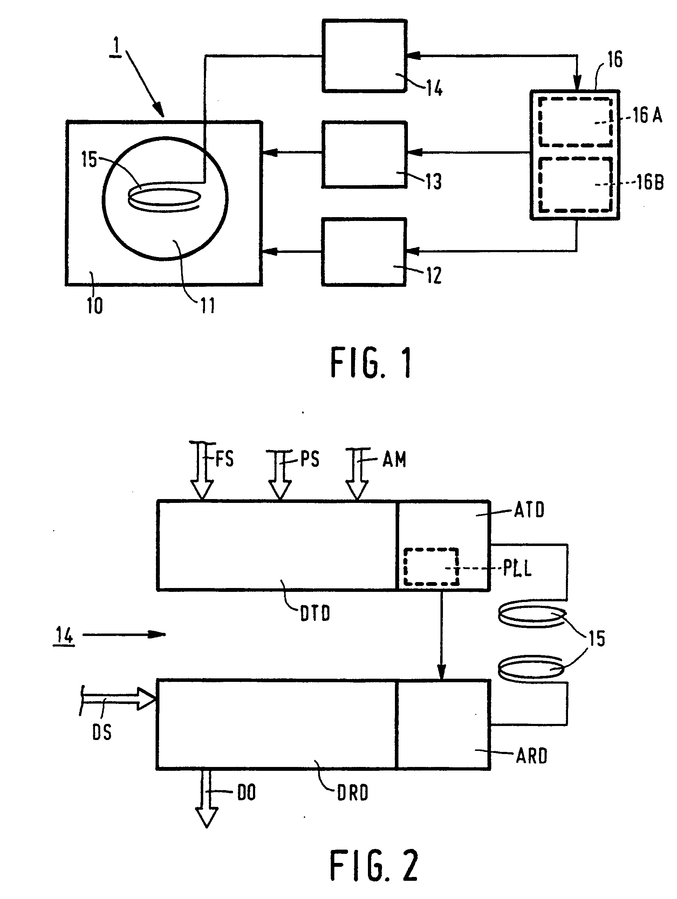

Die in Fig. 1 dargestellte Kernspintomographie-Anlage enthält ein Magnetsystem 10 zum Erzeugen eines statischen homogenen Magnetfelds und zum Erzeugen von Magnetfeldgradienten. Diese Magnetfelder werden in einem Untersuchungsraum 11 erzeugt, in den ein Objekt aufgenommen werden kann, das möchlicherweise ein Patient. Das Magnetsystem 10 wird von den Generatoren 12 und 13 angesteuert, wobei der Generator 12 das statische Magnetfeld und der Generator 13 eines oder mehrere Gradientenmagnetfelder erzeugt, wobei die Gradientenrichtungen dieser Gradientenfelder senkrecht zueinander verlaufen. Die Kernspintomographie-Anlage 1 enthält weiter einen Digitalsender/Empfänger 14, der eine Sende/Empfangsspule 15 ansteuert. Nach dem Ansteuern der Spule 15 sind in dem zu untersuchenden Objekt 11 Resonanzsignale erzeugt, die mit der dann als Empfangsspule arbeitenden Spule 15 detektiert und dem Empfänger im Sender/Emp-fänger 14 zugeleitet werden. Die detektierten Resonanzsignale gelangen in digitaler Form an eine Zentraleinheit 16. Die Vorgänge der Erzeugung, Detektion und Digitalisierung der Kernspinresonanzsignale vom Empfänger 14 werden weiter unten näher erläutert. Die Einheit 16 enthält außer einer Zentralverarbeitungseinheit 16a eine Steuer- und Regeleinheit 16b, die die Generatoren 12 und 13 sowie den Sender und Empfänger 14 steuert und ihre Wirkung synchronisiert. Das Magnetsystem 10 kann eine Widerstandsspule oder eine Supraleitspule sein, die dann vom Generator 12 gesteuert wird. Jedoch kann auch das Magnetsystem 10 einen Dauermagneten zum Erzeugen eines statischen homogenen Magnetfelds enthalten. Im letzten Fall ist selbstverständlich kein Generator 12 erforderlich.

In Fig. 2 ist eine Ausführungsform eines Digitalsenders/Empfängers 14 nach der Erfindung dargestellt. Der Digitalsender/Empfänger 14 enthält einen digitalen Senderteil DTD, einen analogen Senderteil ATD, einen analogen Empfängerteil ARD und einen digitalen Empfängerteil DRD. Der analoge Senderabschnitt ATD ist an die Hochfrequenzspule 15 zum Erzeugen eines Hochfrequenzmagnetfelds angeschlossen. Der analoge Empfängerabschnitt ARD ist ebenfalls an die Hochfrequenzspule 15 zum Empfangen von Kernspinresonanzsignalen angeschlossen. Die Hochfrequenzmagnetspule 15 kann eine einfache Spule sein, an die sowohl der Empfänger ARD als auch der Sender ATD angeschlossen sind, aber diese Hochfrequenzspule kann zum Senden und Empfangen auch zwei getrennte Spulen enthalten.

Der digitale Sendeteil DTD hat drei Eingänge : den ersten Eingang FS für den Frequenzeinstelleingang, einen weiteren Eingang PS für die Phaseneinstellung des Hochfrequenzsignals und einen Eingang AM zum Modulieren des Hochfrequenzsignals. Der Analogabschnitt ATD enthält einen Oszillator mit Phasenregelkreis PLL, von dem ein Ausgang mit einem Eingang des analogen Empfangsabschnitts ARD zum gegenseitigen Abstimmen der Hochfrequenzsende- und Empfangsstufen verbunden ist. Der analoge Sendeabschnitt ATD enthält weiter eine Mischstufe, die die Signale des digitalen Sendeabschnitts DTD und des Oszillators mit Phasenregelkreis PLL empfängt. Auch das Ausgangssignal der Mischstufe kann dem analogen Emfangsabschnitt ARD zugeleitet werden. Dies wird weiter unten näher erläutert. Der digitale Empfangsabschnitt DRD hat einen digitalen Signalausgang DO.

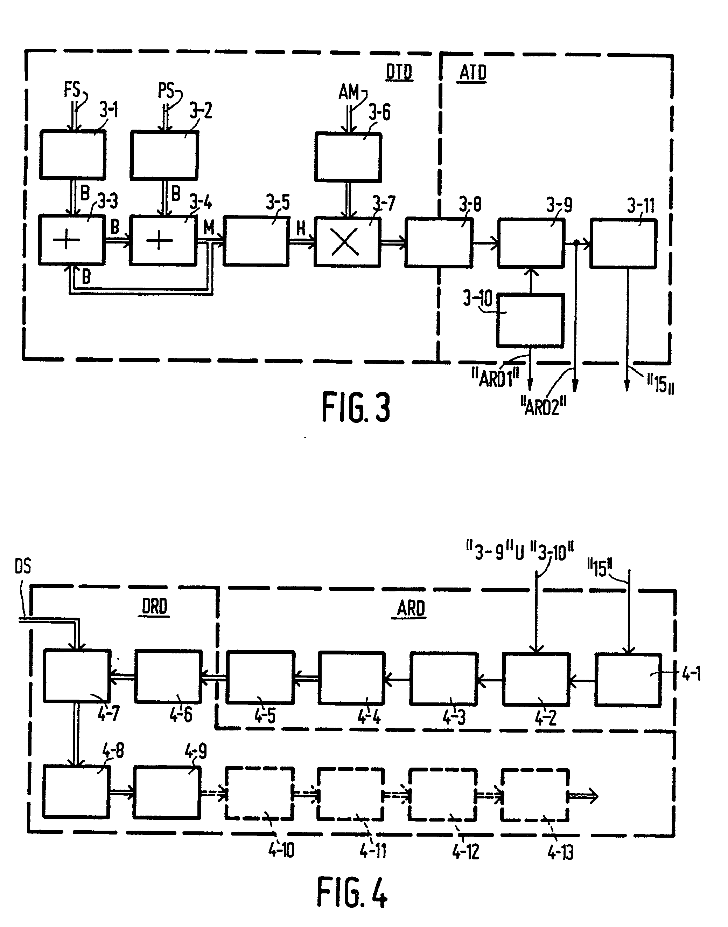

In Fig. 3 ist der Digitalsender DTD, ATD nach Fig. 2 mit weiteren Einzelheiten dargestellt. Der digitale Abschnitt des Senders DTD enthält ein erstes, ein zweites und ein drittes Register 3-1, 3-2, 3-6, deren Anwendung weiter unten näher erläutert wird. Außerdem enthält der digitale Sendeabschnitt DTD einen ersten und einen zweiten Addierer 3-3 und 3-4. Das erste und das zweite Register 3-1 und 3-2 sind mit ihren Ausgängen mit dem Eingang der Addierer 3-3 bzw. 3-4 verbunden. Ein Ausgang des Addierers 3-3 ist mit dem Addierer 3-4 verbunden, dessen Ausgang mit einem weiteren Addiereingang des Addierers 3-3 sowie mit dem Eingang eines Speichers 3-5 verbunden ist. Im Speicher 3-5 ist eine Sinusfunktion gespeichert. Der Ausgang des Speichers 3-5 ist mit einem Vervielfacher 3-7 verbunden, von dem ein weiterer Eingang mit dem Ausgang des dritten Registers 3-6 verbunden ist. Der Ausgang des Vervielfachers 3-7 ist mit dem Eingang eines Digital/Analog-Wandlers 3-8 verbunden, dessen Ausgang an eine Sendefrequenzmischstufe 3-9 angeschlossen ist. Ein weiterer Eingang der Sendefrequenzmischstufe 3-9 ist an einen Ausgang eines Oszillators mit Phasenregelkreis 3-10 angeschlossen, von dem ein weiterer Ausgang "ARD1" dem analogen Empfängerabschnitt ARD zugeleitet werden kann. Der Ausgang "ARD2" der Sendefrequenzmischstufe 3-9 ist an einen Eingang eines Leistungsverstärkers 3-11 angeschlossen, dessen Ausgang mit der Hochfrequenzspule 15 verbunden ist.

Die Wirkung des Digitalsenders entsprechend Fig. 3 sieht wie folgt aus. Die im Register 3-1 gespeicherte Digitalzahl wird im Addierer 3-3 zu der am Ausgang des Addierers 3-4 befindlichen Digitalzahl addiert. Die Addierung dieser beiden Digitalzahlen gelangt an den ersten Eingang des Addierers 3-4, der an einem weiteren Eingang die im Register 3-2 gespeicherte Digitalzahl addiert. Die vom Addierer 3-4 gelieferte Summe dient als Adresse für die im Speicher 3-5 gespeicherte Sinustabelle (LUT-Look Up Table). Wenn angenommen sei, daß im Register 3-2 die Zahl Null und im Register 3-1 die Digitalzahl 1 gespeichert ist, wird am Ausgang des Addierers 3-4 nach jedem Addierschritt die dort entstandene Zahl stets um 1 erhöht, wodurch eine Tabelle, die im Speicher 3-5 gespeichert ist, Schritt für Schritt durchlaufen wird. Wird jetzt im Register 3-1 eine größere Zahl als 1 gespeichert, werden die aufeinanderfolgenden Zahlen am Ausgang des Addierers 3-4 in den aufeinanderfolgenden Addierschritten immer um diese Zahl erhöht, wodurch die im Speicher 3-5 gespeicherte Sinustabelle schneller durchlaufen wird. Das Ergebnis obiger Beschreibung ist, daß am Ausgang des Speichers 3-5 ein sinusförmiges Signal mit einer höheren Frequenz erzeugt wird. Die im Register 3-1 gespeicherte Zahl bestimmt also die Frequenz an Ausgang des Speichers 3-5. Wird jetzt in einem vorbeschriebenen Zyklus von Addierungen einmalig eine zusätzliche Zahl addiert, die im Register 3-2 gespeichert ist, wird das regelmäßige Durchlaufen der Sinustabelle im Speicher 3-5 einmalig gestört, was bedeutet, daß in dem am Ausgang des Speichers 3-5 erzeugten sinusförmigen Signal faktisch ein Phasensprung erfolgt. Mit der gegebenen Konfiguration ist es möglich, am Ausgang des Speichers 3-5 ein sinusförmiges Signal zu erzeugen, von dem sowohl die Frequenz als auch die Phase Sprünge aufweisen kann. Diese Sprünge sind dadurch möglich, daß der Inhalt der Register 3-1 bzw. 3-2 über den Frequenzeinstelleingang FS bzw. den Phaseneinstelleingang

PS geändert wird. Ändert sich in einem Zyklus von Addierungen nach jeder Addierung die Zahl im Register 3-1 (d.h. sie wird erhöht oder erniedrigt), so wird am Ausgang des Speichers 3-5 ein FM-Signal erzeugt.

Der Ausgang des Speichers 3-5 ist mit einem ersten Eingang des Vervielfachers 3-7 verbunden, dessen anderer Eingang mit dem Register 3-6 verbunden ist. In das Register 3-6 wird eine Zahl eingeschrieben, die ein Maß für die Amplitude des sinusförmigen Signals ist, das über den Ausgang des Vervielfachers 3-7 dem Digital/Analog-Wandler 3-8 zugeführt wird. Es sei bemerkt, daß der Ausgang des Vervielfachers 3-7 und der Ausgang des Digital/Analog-Wandlers 3-8 ein Signal in digitaler bzw. in analoger Form ausgeben, das sowohl frequenz- als auch phasenmäßig in der Amplitude moduliert sein kann. Dieses Signal wird in der Sendefrequenzmischstufe 3-9 mit dem Hochfrequenzsignal des phasenverriegelten Oszillators 3-10 moduliert. Der Ausgang der Sendefrequenzmischstufe 3-9 gelangt an den selektiven Hochfrequenzleistungsverstärker. Mit dem digitalen Frequenzsynthesizer werden Signale mit Frequenzen bis 1000 kHz erzeugt, die die Sendefrequenzmischstufe 3-9 mit dem Signal des PLL-Oszillators 3-10 vermischt, so daß das Ausgangssignal auf einer für Kernspintomographie-Untersuchungen geeigneten Frequenz kommt (beispielsweise für Protonenuntersuchung bei einer Stärke von 1.5 T des statischen Magnetfelds : 63,86 MHz). Abhängig vom benutzten Mischstufentyp 3-9 muß der Leistungsverstärker 3-10 möglicherweise ein selektiver Vorverstärker sein. Wenn die Frequenzmischstufe 3-9 ein Einseitenbandmodulator mit einer Bildablehnungsbetriebsart ist, braucht der Verstärker 3-11 nicht selektiv zu sein.

In Fig. 4 ist ein Digitalempfänger nach Fig. 2 mit weiteren Einzelheiten dargestellt. Der analoge Empfangsabschnitt ARD enthält einen selektiven Vorverstärker 4-1, eine Empfangsfrequenzmischstufe 4-2, einen Zwischenfrequenzverstärker 4-3, ein Frequenzbanddurchlaßfilter 4-4 und einen Analog/Digital-Wandler 4-5. Der Eingang des Vorverstärkers 4-1 ist mit der Hochfrequenzdetektorspule 15 verbunden. Die mit der Hochfrequenzspule 15 detektierten und vom Vorverstärker 4-1 verstärkten Kernspinresonanzsignale gelangen an die Mischstufe 4-2, die weiter an einem zweiten Eingang entweder das Hochfrequenzsignal des phasenverriegelten Oszillators 3-10 oder das Hochfrequenzausgangssignal der Mischstufe 3-9 empfängt. Das am Ausgang der Mischstufe 4-2 erzeugte Zwischenfrequenzsignal wird im Verstärker 4-3 verstärkt, im Bandfilter 4-4 filtriert und dem Digital/Analog-Wandler 4-5 zugeführt. Die aus dem Analog/Digital-Wandler 4-5 herrührenden Digitalsignale gelangen an eine Fourier-Transformationsschaltung 4-6. Die Fourier-Transformationsschaltung 4-6 wandelt die Signale aus der Zeitdomäne in Signale in einer Frequenzdomäne um. Weiter ist mit dieser Fourier-Transformationsschaltung 4-6 das gewünschte Frequenzband aus den verfügbaren, sortierten Signalproben erzeugbar. Dies Frequenzsignale gelangen an eine Phasenkorrekturschaltung 4-7, die über eine Verbindung DS mit der Steuer- und Regeleinheit 16b Phasenkorrektursignale empfängt. Dies wird weiter unten näher erläutert. Nach der Phasenkorrektur werden diese Frequenzsignale einer Summierungsschaltung 4-8 zugeführt, die aus den zusammengehörenden Frequenzsignalen einen Mittelwert bestimmt.

Die Empfängerschaltung DRD enthält weiter eine Sortierschaltung 4-9, die die aufeinanderfolgend erhaltenen Spektren in eine zu wählende Reihenfolge bringt. Die Reihenfolge der Meßsequenzen braucht nämlich nicht der Reihenfolge zu entsprechen, in der die Spektren verarbeitet werden. Zum Beispiel ist für die Bestimmung eines zweiten dimensionalen Bildes die Reihenfolge der Spektren für Verarbeitung vom Zeitintegral der Stärke eines Vorbereitungs-Gradientenmagnetfelds in einer Vorbereitungsperiode zwischen dem Senden der Hf-Energie und dem Empfang des Resonanzsignals festgelegt. Die Reihenfolge läuft in Schritten mit einem Mindestwert dieses Integrals bis zu einem Höchstwert (oder umgekehrt). Die Meßsequenzen brauchen nicht unbedingt in dieser Reihenfolge durchgeführt zu werden.

Die sortierten Spektren werden über einen Inverse-Fast-Fourier-Transformator 4-10 wieder in Zeitsignale umgewandelt, wonach die Zeitsignale eine Gewichtung erfahren, um Geräuscheinflüße auf die Signale dadurch herabzusetzen, daß die Teile der Signale mit einem niedrigen Signal/Rausch-Verhältnis mit einem Gewichtungsfaktor unter 1 multipliziert werden.

In der Expansionsschaltung 4-11 werden den Zeitsignalen, die aus einer diskreten Anzahl von Amplitudenwerten bestehen, eine gleich große Anzahl von Werten Null zugefügt. Das Ergebnis dieser Operation ist, daß in der folgenden Fouriertransformation in der Schaltung 4-13 eine fiktiv höhere Auflösung erhalten wird (eine größere Anzahl von Bildpunkten wird erhalten, jedoch steigt die räumliche Auflösung der Information im rekonstruierten Bild nicht an).

Der Ausgang 4-14 des Fouriertransformators 4-13 ergibt ein Bild einer gemessenen Kernspinresonanzverteilung, die eine Kernspindichteverteilung sein kann, aber auch ein (räumlich bestimmtes) Spektrum.

Eine weitere möglichkeit zum Verarbeiten der detektierten Kernspinresonanzsignale wird dadurch erhalten, daß die mit "3-10" markierte Eingang der Frequenzmischstufe 4-2 mit dem Ausgang "ARD2" des Einseitenbandmodulators 3-9 (siehe Fig. 3) des analogen Sendeabschnitts ARD verbunden wird.

Die Wirkung des Sender/Empfängers in Fig. 3 und Fig. 4 ist wie folgt. Der Synthesizerabschnitt DTD erzeugt eine Frequenz von 300 kHz und der Oszillator PLL eine Frequenz von 63,56 MHz. Im Objekt wird nunmehr eine Scheibe mit einem Gradientenmagnetfeld $G_z$ (Gradient in der z-Richtung) ausgewählt, wobei z gleich Null ist (die Resonanzfrequenz beträgt in einem 1,5 T Magnetsystem : 63,86 MHz). Es sei angenommen, daß das Resonanzsignal bei einem Gradientenmagnetfeld $G_y$ detektiert wird, das eine Bandbreite von 100 kHz bewirkt. Das in der Spule 15 eingefangene Signal liegt zwischen den Frequenzen 63,81 und 63,91 MHz. Im Empfängerabschnitt ARD wird in der Mischstufe 4-2 das Signal mit dem Signal des Oszillators PLL gemischt. Das Ausgangssignal der Mischstufe 4-2 hat ein zwischen 250 und 350 kHz liegendes Frequenzband. Nach dem Durchgang durch den Zwischenfrequenzverstärker 4-3 und dem Banddurchlaßfilter 4-4 wird dieses Signal vom Analog/Digital-Wandler 4-5 mit einer Frequenz von 243 kHz unterabgetastet. Durch Rückfaltungseffekte infolge dieser Unterabtastung wird am Ausgang des A/D-Wandlers 4-5 ein Signal mit einem Frequenzband zwischen 7 und 107 kHz erzeugt. Die vorbeschriebene Anordnung bewirkt, daß die Information des Resonanzsignals in bezug auf 0 Hz einseitig liegt und daß beim Empfang des Resonanzsignals der Sender auf eine Frequenz abgestimmt ist, die außerhalb des empfangenen Frequenzbands liegt, so daß kein Übersprechen erfolgt.

In einer erfindungsgemäßen Ausführungsform gelangt das Ausgangssignaal der Frequenzmischstufe 3-9 zur Frequenzmischstufe 4-2 im Empfänger ARD. Ohne weitere Maßnahmen würde beim Empfang eines Resonanzsignals das Ausgangssignal ein Frequenzband besitzen, das um die Frequenz 0 Hz herum liegt. Erfindungsgemäß wird beim Übergang vom Senden nach Empfangen ein Frequenzsprung bei dem im Digitalsynthesizer DTD erzeugten Signal. Die Sprunggröße beträgt die Hälfte der Bandbreite des zu detektierenden Resonanzsignals, vergrößert um einen Konstantwert $\Delta$ beispielsweise 5 oder 10 kHz. Das Ergebnis dabei ist, daß bei einer Bandbreite von 90 kHz und bei einem Wert $\Delta = 5$ kHz die Frequenz im digitalen Sendeabschnitt DTD um einen Betrag von 50 kHz versprigt. Der Ausgang der Mischstufe 4-2 hat einen Frequenzbereich zwischen 5 und 95 kHz. Das Bandfilter 4-4 kann für jede Meßsequenz stets dieselbe sein und braucht nicht, wie beim Stand der Technik, einer Messung angeglichen zu werden. Der Analog/Digital-Wandler 4-5 kann mit einer Frequenz von 200 kHz eine Normalabtastung durchführen. Es sei bemerkt, daß bei Mehrscheibentechniken der Frequenzsprung im digitalen Sendeabschnitt DFD einen Wert von $\Delta + 1/2$ (Signalbandbreite) + Offset-Frequenz, beispielsweise $\Delta = 5$ kHz, hat.

1/2 (Signalbandbreite) = 45 kHz

Offset-Frequenz = $\gamma \cdot z \cdot G_z$ wobei z die Position der ausgewählten Scheibe ist. Aus obiger Beschreibung geht klar hervor, daß das Ausgangssignal der Mischstufe 4-2 jetzt immer im gleichen Frequenzband gehalten werden kann, was besonders vorteilhaft ist.

Die in Fig. 4 dargestellte Phasenkorrekturschaltung 4-7 ist nicht immer notwendig. Wenn in jedem Meßzyklus immer bei gleicher Phase des vom digitalen Sendeabschnitt zu erzeugenden Signals gestartet wird (mit anderen Worten der Meßzyklus wird von der Phase des DTD getriggert), ist der Phasenunterschied zwischen den Resonanzsignalen (beispielsweise zum Echozeitpunkt bei Spinechotechnik) immer eine ganze Anzahl Male $2\pi$.

Wenn Obiges nicht angewandt wird, kann die Steuer- und Regeleinheit 16b aus den aufeinanderfolgenden Steuersignalen FS und PS, die an den digitalen Sendeabschnitt DTD gelangen, ableiten, wie groß die Phasenunterschiede DS in den aufeinanderfolgenden Resonanzsignalen sind, wobei dieser Phasenunterschied DS als Steuersignal an die Phasenkorrekturschaltung gelangt.

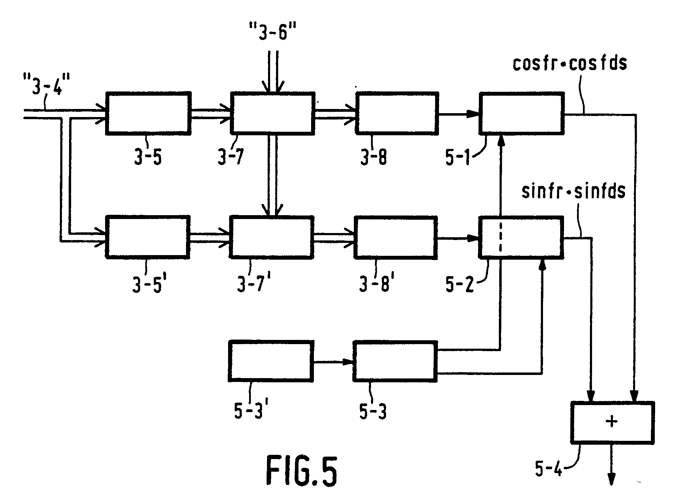

Falls die Frequenzmischstufe 3-9 ein Einseitenbandmodulator ist, kann er auf vorteilhafte Weise in einer in Fig. 5 dargestellten Konfiguration in einem Digitalsender benutzt werden. Die Frequenzmischstufe 3-9 enthält einen ersten und einen zweiten Vervielfacher 5-1 und 5-2, einen Phasendreher 5-3 und eine Addierschaltung 5-4. An den Phasendreher 5-3 gelangt ein Bezugssignal mit der Frequenz fr. Ein erster Ausgang des Phasendrehers erzeugt ein Signal $(\cos(2\pi \cdot fr \cdot t))$, das um 90° in der Phase zum Signal $(\sin(2\pi \cdot fr \cdot t))$, das an einen zweiten Ausgang gelangt, verschoben ist. Die Ausgangssignale des ersten und des zweiten Vervielfachers 5-1 bzw. 5-2 gelangen an die Addierschaltung 5-4. Einem zweiten Eingang der Vervielfacher 5-1 und 5-2 wird das im Digitalsynthesizer erzeugte Signal mit der Frequenz fds zugeführt, wobei der Phasenunterschied zwischen den dem ersten und dem zweiten Vervielfacher zugeführten Signalen entweder 90 oder -90° beträgt. Der Vervielfacher 5-1 empfängt von Signal der Bezugsfrequenz die Kosinusfunktion und vom Signal des Digitalsynthesizers mit der Frequenz fds ebenfalls die Kosinusfunktion. Der Vervielfacher 5-2 empfängt aus dem Bezugsfrequenzsignalgenerator 5-3 und 5-3', von denen 5-3' der Oszillator des Bezugsfrequenzsignals fr ist, die Sinusfunktion un vom Signal des Digitalsynthesizers mit der Frequenz fds gleichfalls die Sinusfunktion. Der vom Vervielfacher 5-1 gebildete Produkt $\cos(fr) \cdot \cos(fds)$ ist gleich $\cos(fr - fds) + \cos(fr + fds)$. Das vom Vervielfacher 5-2 erzeugte Produktsignal ist gleich $\cos(fr - fds) - \cos(fr + fds)$. Die Summe der beiden Signale ergibt ein Signal mit der Funktion $\cos(fr - fds)$. Auch ist es möglich ein Signal mit einer Frequenz gleich dem Unterschied zwischen den Frequenzen fr und fds zu erhalten, wenn statt einer Addier- eine Subtrahierschaltung verwendet wird. Jedoch wäre dabei eine Umschaltung von Addieren nach Subtrahieren erforderlich, wodurch zusätzliche Hardware erfordert wird.

Die Kosinus- und Sinusfunktion des Signals mit der Frequenz fdr, die dem Vervielfacher 5-1 bzw. 5-2 zugeführt werden, werden wie folgt erzeugt. Neben der Suchtabelle 3-5 nach Fig. 5 wird eine weitere Suchtabelle 3-5' angewandt, in der eine Sinustabelle gespeichert ist, während in der Tabelle 3-5 eine Kosinustabelle gespeichert ist. Mit einer selben Adresse, die vom Register 3-4 (siehe Fig. 2) zugeführt wird, werden simultan eine Kosinus- und eine Sinusfunktion in einer Tabelle 3-5 bzw. 3-5' gesucht. Diese Funktion gelangt an einem Vervielfacher 3-7 bzw. 3-7'. Die beiden Vervielfacher 3-7 und 3-7' empfangen aus dem Register 3-6 (siehe Fig. 3) den Wert, mit dem die den Vervielfachern 3-7 und 3-7' zugeführten Funktionswerte vervielfacht werden müssen. Das Ergebnis der Vervielfachungen gelangt an die Digital/Analog-Wandler 3-8 und 3-8', deren Ausgang mit den Eingängen der Vervielfacher 5-1 und 5-2 verbunden ist.

Es ist selbstverständlich möglich, die in Fig. 5 dargestellte Hardware-Größe zu verringern. Statt zwei Suchtabellen, zwei Vervielfacher und zwei Digital/Analog-Wandler ist dies möglich durch Verwendung einer Demultiplexschaltung, deren einem Eingang eine Adresse des Registers 3-4 und deren zweitem Eingang eine weitere Adresse zugeführt wird, die von der erstgenannten Adresse abgeleitet wird. Diese Ableitung kann auf ziemlich einfache Weise erfolgen, weil die zu suchenden Sinuswerte in der Tabelle stets um 90° auseinanderliegen müssen. Mit diesen beiden Adressen werden aufeinanderfolgend stets ein Kosinus- und ein Sinuswert aus der Tabelle gelesen, die darauf über die Vervielfacher 3-7 und 3-8 und eine daran angeschlossene weitere Multiplexschaltung aufeinanderfolgend den Vervielfachern 5-1 und 5-2 zugeführt werden.

Das in Fig. 5 dargestellte Beispiel bietet den Vorteil, daß sowohl positive als auch "negative" Frequenzen erzeugbar sinds, d.h. das vom Einseitenband erzeugte Frequenzband kann sowohl über als auch unter der dem Modulator zugeführten Frequenz fr liegen.

**Patentansprüche**

1. Kernspintomographie-Anlage mit einem Magnetsystem zum Erzeugen eines statischen homogenen Magnetfelds und zum Erzeugen magnetischer Gradientenfelder, mit einem Hf-Sender und Hf-Empfänger zum Erzeugen und Detektieren von Kernspinresonanzsignalen und mit einer Verarbeitungs- und Steueranordnung zum Verarbeiten der detektierten Resonanzsignale zum Steuern des Hf-Senders und Hf-Empfängers und des Magnetsystems, wobei der Sender ein Sendesignal erzeugt, dessen Sendefrequenz von der Frequenz eines dem Empfänger zuzuführenden Bezugssignals zum Demodulieren eines mit dem Sendesignal erzeugten Resonanzsignals abweicht, wobei eine Abtastschaltung zum Abtasten des demodulierten Resonanzsignals vorgesehen ist, dadurch gekennzeichnet, daß das dem Empfänger zugeführte Bezugssignal eine derartige Frequenz hat, daß das Frequenzband des demodulierten und abgetasten Signals in bezug auf die Frequenz 0 Hz einseitig liegt, wobei weiter Mittel zum Beibehalten einer Phaseninformation der Resonanzsignale in aufeinanderfolgenden Meßsequenzen vorgesehen sind.

2. Kernspintomographie-Anlage nach Anspruch 1, dadurch gekennzeichnet, daß der Sender/Empfänger ein Hybrid-Sender/Empfänger ist, wobei der Sender außer einem Digitalfrequenzsynthesizer einen Digital/Analog-Wandler, eine Sendefrequenzmischstufe und einen Hochfrequenzleistungsverstärker enthält, die in Reihe aneinander angeschlossen sind, wobei der Empfänger einen Vorverstäker, eine Empfangsfrequenzmischstufe und einen Analog/Digital-Wandler enthält, die in Reihe geschaltet sind, wobei die Sendefrequenzmischstufe an einen Ausgang eines Oszillators mit Phasenregelkreis angeschlossen ist, wobei die Empfangsfrequenzmischstufe entweder an den Ausgang des Oszillators mit Phasenregelkreis oder an den Ausgang der Sendefrequenzmischstufe angeschlossen ist.

3. Kernspintomographie-Anlage nach Anspruch 1, dadurch gekennzeichnet, daß der Digitalfrequenzsynthesizer einen Speicher enthält, in dem eine Sinusspannungsform in Tabellenform gespeichert ist, und von dem ein Adreßeingang mit einem Ausgang einer Addierschaltung verbunden ist, deren Addiereingänge an einen Ausgang einer weiteren Addierschaltung bzw. an ein erstes Register angeschlossen sind, wobei von der weiteren Addierschaltung ein erster Eingang mit einem zweiten Register und mit dem Ausgang der erstgenannten Addierschaltung verbunden ist.

4. Kernspintomographie-Anlage nach Anspruch 3, dadurch gekennzeichnet, daß der Ausgang des Speichers über einen Multiplikator mit dem Eingang eines Digital/Analog-Wandlers verbunden ist, wobei ein Eingang der Multiplikationsschaltung an ein drittes Register angeschlossen ist.

5. Kernspintomographie-Anlage nach Anspruch 3 oder 4, dadurch gekennzeichnet, daß Eingänge des ersten, zweiten und dritten Registers mit Ausgängen einer Steuer- und Regeleinheit zum Einstellen der Frequenz, der Phase und der Amplitude eines dem Digital/Analog-Wandler zuzuführenden Signals verbunden sind.

6. Kernspintomographie-Anlage nach Anspruch 2, 3, 4 oder 5, dadurch gekennzeichnet, daß die Abtastfrequenz des Analog/Digital-Wandlers niedriger als die Frequenzen der Ausgangssignale der Frequenzmischstufe ist.

7. Kernspintomographie-Anlage nach Anspruch 2 oder 6, dadurch gekennzeichnet, daß der Analog/Digital-Wandler des Empfängers über eine Fourier-Transformationsschaltung an eine Phasenkorrekturschaltung angeschlossen ist, von der ein weiterer Eingang mit der Steuer- und Regeleinheit für den Empfang eines Phasenkorrektursignals verbunden ist.

8. Kernspintomographie-Anlage nach Anspruch 7, dadurch gekennzeichnet, daß der Ausgang der Phasenkorrekturschaltung an eine Berechnungsschaltung zum Bestimmen eines Mittelwerts aus zueinander gehörenden Frequenzsignalen angeschlossen ist.

9. Kernspintomographie-Anlage nach einem der Ansprüche 2, 3, 4, 5 oder 6, dadurch gekennzeichnet, daß die Sendefrequenz-Mischstufe ein Einseitenbandmodulator mit einem ersten und einem zweiten Vervielfacher enthält, deren Ausgänge an eine Addierschaltung angeschlossen sind und wobei ein erster Ausgang des ersten bzw. des zweiten Vervielfachers ein Bezugssignal mit einer ersten bzw. einer zweiten Phase empfangen, wobei der Phasenunterschied zwischen den Bezugssignalen 90° beträgt und daß der Digitalsynthesizer an einen zweiten Eingang des ersten bzw. des zweiten Vervielfachers ein erstes bzw. ein zweites Signal legt, wobei der Phasenunterschied zwischen den Signalen an den zweiten Eingängen der Vervielfacher 90° beträgt oder eines der vom Synthesizer gelieferten Signale invertierbar ist.

10. Kernspintomographie-Anlage nach Anspruch 1, 2 oder 3, dadurch gekennzeichnet, daß im eingeschalteten Zustand des Empfängers zum Empfangen eines mit der Sendefrequenz erzeugten Resonanzsignals das Sendesignal eine von der Sendefrequenz abweichende Frequenz hat.

## Claims

1. An apparatus for nuclear spin tomography, comprising a magnet system for generating a steady, uniform, magnetic field and for generating magnetic gradient fields, an r.f. transmitter and r.f. receiver for generating and detecting spin resonance signals, and a processing and control device for processing the detected resonance signals and for controlling the r.f. transmitter and r.f. receiver and the magnet system, the transmitter generating a transmission signal whose frequency deviates from the frequency of a reference signal to be applied to the receiver for demodulating a resonance signal generated by means of the transmission signal, there also being provided a sampling circuit for sampling the demodulated resonance signal, characterized in that the reference signal applied to the receiver has a frequency such that the frequency band of the demodulated and sampled signal is situated to one side of the frequency 0 Hz, there also being provided means for retaining phase information of the resonance signals in successive measurement sequences.

2. An apparatus for nuclear spin tomography as claimed in Claim 1, characterized in that the transmitter/receiver is a hybrid transmitter/receiver, the transmitter comprising not only a digital frequency synthesizer but also a digital-to-analog converter, a transmission frequency mixing stage, and an r.f. power amplifier which are connected in series, the receiver comprising a pre-amplifier, a reception frequency mixing stage, and an analog-to-digital converter which are connected in series, the transmission frequency mixing stage being connected to an outupt of a phase locked loop oscillator, the reception frequency mixing stage being connected either to the output of the phase locked loop oscillator or to the output of the transmission frequency mixing stage.

3. An apparatus for nuclear spin tomography as claimed in Claim 1, characterized in that the digital frequency synthesizer comprises a memory in which a sinusoidal waveform is stored in a table, an address input thereof being connected to an output of an adder circuit, the add inputs of which are connected to an output of a further adder circuit or to a first register, respectively, a first input of said further adder circuit being connected to a second register and to the output of the former adder circuit.

4. An apparatus for nuclear spin tomography as claimed in Claim 3, characterized in that the output of the memory is connected to the input of a digital-to-analog converter via a multiplier, an input of the multiplier circuit being connected to a third register.

5. An apparatus for nuclear spin tomography as claimed in Claim 3 of 4, characterized in that inputs of the first, the second and the third register are connected to outputs of a control unit for adjusting the frequency, the phase and the amplitude of a signal to be applied to the digital-to-analog converter.

6. An apparatus for nuclear spin tomography as claimed in Claim 2, 3, 4 or 5, characterized in that the sampling frequency of the analog-to-digital converter is lower than the fequencies of the output signals of the frequency mixing stage.

7. An apparatus for nuclear spin tomography as claimed in the Claims 2 or 6, characterized in that the analog-to-digital converter of the receiver is connected, via a Fourier transformation circuit, to a phase correction circuit, a further input of which is connected to the control unit in order to receive a phase correction signal.

8. An apparatus for nuclear spin tomography as claimed in Claim 7, characterized in that the output of the phase correction circuit is connected to an arithmetic circuit for determining a mean value from associated frequency signals.

9. An apparatus for nuclear spin tomography as claimed in Claim 2, 3, 4, 5 or 6, characterized in that the transmission frequency mixing stage comprises a single-sideband modulator which comprises a first and a second multiplier whose outputs are connected to an adder circuit, a first output of the first and the second multiplier receiving a reference signal having a first phase and a second phase, respectively, the phase difference between the reference signals amounting to 90°, a second input of the first multiplier and the second multiplier receiving a first and a second signal, respectively, from the digital synthesizer, the phase difference between the signals on the second inputs of the multipliers amounting to 90° or one of the signals supplied by the synthesizer being invertable.

10. An apparatus for nuclear spin tomography as claimed in Claim 1, 2 or 3, characterized in that in the state in which the receiver is activated for the reception of a resonance signal generated with the transmission frequency the transmission signal has a frequency which deviates from the transmission frequency.

## Revendications

1. Appareil de tomographie RMN comportant un système d'aimants pour produire un champ magnétique homogène statique et pour produire des champs de gradients magnétiques, un émetteur Hf et un récepteur Hf pour produire et détecter des signaux de résonance magnétique nucléaire et un dispositif de traitement et de commande pour traiter les signaux de résonance détectés en vue de commander l'émetteur Hf et le récepteur Hf, de même que le système d'aimants, l'émetteur produisant un signal d'émission dont la fréquence d'émission s'écarte de la fréquence d'un signal de référence à appliquer au récepteur pour la démodulation d'un signal de résonance produit avec le signal d'émission, un circuit d'échantillonnage étant prévu pour échantillonner le signal de résonance démodulé, caractérisé en ce que le signal de référence appliqué au récepteur a une fréquence telle que la bande de fréquence du signal de résonance démodulé et échantillonné se situe d'un seul côté de la fréquence de 0 Hz, des moyens étant, en outre, prévus pour conserver une information de phase des signaux de résonance dans les séquences de mesure successives.

2. Appareil de tomographie RMN suivant la revendication 1, caractérisé en ce que l'émetteur/récepteur est un émetteur/récepteur hybride, dans lequel l'émetteur comprend, en dehors d'un synthétiseur de fréquence numérique, un convertisseur numérique/analogique, un étage mélangeur de fréquence d'émission et un amplificateur de puissance Hf, qui sont connectés en série, le récepteur comprenant un préamplificateur, un étage mélangeur de fréquence de réception et un convertisseur analogique/numérique, qui sont connectés en série, l'étage mélangeur de fréquence d'émission étant connecté à une sortie d'un oscillateur à circuit de régulation de phase et l'étage mélangeur de fréquence de réception étant connecté soit à la sortie de l'oscillateur à circuit de régulation de phase, soit à la sortie de l'étage mélangeur de fréquence d'émission.

3. Appareil de tomographie RMN suivant la revendication 1, caractérisé en ce le synthétiseur de fréquence numérique comprend une mémoire dans laquelle une forme de tension sinusoïdale est stockée sous forme de table et dont une entrée d'adresse est connectée à une sortie d'un circuit additionneur, dont les entrées d'addition sont connectées respectivement à une sortie d'un autre circuit additionneur ou à un premier registre, une première entrée de l'autre circuit additionneur étant connectée à un second registre et à la sortie du circuit additionneur mentionné en premier lieu.

4. Appareil de tomographie RMN suivant la revendication 3, caractérisé en ce que la sortie de la mémoire est connectée, par l'intermédiaire d'un multiplicateur, à l'entrée d'un convertisseur numérique/analogique, une entrée du circuit de multiplication étant connectée à un troisième registre.

5. Appareil de tomographie RMN suivant la revendication 3 ou 4, caractérisé en ce que des entrées du premier, du deuxième et du troisième registre sont connectées à des sorties d'une unité de commande et de régulation pour régler la fréquence, la phase et l'amplitude d'un signal à appliquer au convertisseur numérique/analogique.

6. Appareil de tomographie RMN suivant la revendication 2, 3, 4 ou 5, caractérisé en ce que la fréquence d'échantillonnage du convertisseur analogique/numérique est inférieure aux fréquences des signaux de sortie de l'étage mélangeur de fréquence.

7. Appareil de tomographie RMN suivant la revendication 2 ou 6, caractérisé en ce que le convertisseur analogique/numérique du récepteur est connecté, par l'intermédiaire d'un circuit de transformation de Fourier, à un circuit correcteur de phase, dont une autre entrée est connectée à l'entrée de commande et de régulation pour la réception d'un signal de correction de phase.

8. Appareil de tomographie RMN suivant la revendication 7, caractérisé en ce que la sortie du circuit correcteur de phase est connectée à un circuit de calcul pour la détermination d'une valeur moyenne à partir de signaux de fréquence associés.

9. Appareil de tomographie RMN suivant l'une quelconque des revendications 2, 3, 4, 5 ou 6, caractérisé en ce que l'étage mélangeur de fréquence d'émission comprend un modulateur à bande latérale unique comportant un premier et un second multiplicateur, dont les sorties sont connectées à un circuit additionneur, une première sortie respective du premier ou du second multiplicateur recevant un signal de référence d'une première ou d'une seconde phase respective, la différence de phase entre les signaux de référence s'élevant à 90°, et que le synthétiseur numérique applique à une seconde entrée respective du premier ou du second multiplicateur un premier ou un second signal respectif, la différence de phase entre les signaux aux secondes entrées des multiplicateurs s'élevant à 90° ou un des signaux fournis par le synthétiseur étant inversible.

10. Appareil de tomographie RMN suivant les revendications 1, 2 ou 3, caractérisé en ce que, dans l'état enclenché du récepteur pour la réception d'un signal de résonance produit à la fréquence d'émission, le signal d'émission a une fréquence déviant de la fréquence d'émission.

FIG. 1

FIG. 2

FIG. 3

FIG. 4

FIG.5